# EUROPÄISCHE PATENTSCHRIFT

(11) **EP 3 605 846 B1**
(45) Veröffentlichungstag und Bekanntmachung des Hinweises auf die Patenterteilung: **21.07.2021**
(21) Anmeldenummer: 18187027.0
(22) Anmeldetag: 02.08.2018
(51) Int. Cl.: H03M 1/06, H03M 1/18

(54) **VERFAHREN UND SCHALTUNGSANORDNUNG ZUR ANALOG/DIGITALWANDLUNG ELEKTRISCHER SIGNALE**
METHOD AND CIRCUIT ARRANGEMENT FOR ANALOG/DIGITAL CONVERSION OF ELECTRICAL SIGNALS
PROCÉDÉ ET DISPOSITIF DE COMMUTATION DESTINÉS À LA CONVERSION ANALOGIQUE / NUMÉRIQUE DES SIGNAUX ÉLECTRIQUES

(43) Veröffentlichungstag der Anmeldung: 05.02.2020
(73) Patentinhaber: Helmut-Schmidt-Universität, Universität der Bundeswehr Hamburg, 22043 Hamburg (DE)
(72) Erfinder: Urbansky, Lars, 22041 Hamburg (DE); Zölzer, Udo, 21629 Neu Wulmstorf (DE)
(74) Vertreter: Stüven, Ralf

(56) Entgegenhaltungen:
- WO-A1-01/99285
- US-A1- 2002 012 405

## Beschreibung

Die Erfindung betrifft ein Verfahren und eine Schaltungsanordnung zur Analog/Digitalwandlung elektrischer Signale.

Analog/Digitalwandler (A/D-Wandler) sind allgemein bekannt und dienen dazu, ein zeit- und wertkontinuierliches (analoges) Eingangssignal x(t) durch Abtastung mit einer Abtastrate oder Abtastfrequenz fs in ein zeitdiskretes und durch Quantisierung in ein quantisiertes und damit digitales Ausgangssignal x(n) umzuwandeln.

Einer der Parameter eines A/D-Wandlers hinsichtlich der Quantisierung der zeitdiskreten Signalwerte ist der Dynamikumfang oder Dynamikbereich, d.h. das Verhältnis zwischen einem quantisierbaren maximalen Signalwert und dem Rauschen am Ausgang, wenn der anliegende Signalwert Null ist.

Zur Vergrößerung des Dynamikbereiches ist es bekannt, dem A/D-Wandler eine automatische Verstärkungssteuerung oder -regelung (AGC - automatic gain control) vorzuschalten, mit der das Eingangssignal vor der Digitalwandlung verstärkt oder gedämpft wird. Das Steuersignal für die AGC ist ein DC- oder ein sich nur geringfügig veränderndes Signal, das allerdings durch das 1/f-Rauschen stark beeinträchtigt ist.

Weiterhin ist es zur Vergrößerung des Dynamikbereiches bekannt, zwei oder mehr A/D-Wandler mit unterschiedlichen Verstärkungsfaktoren parallel einzusetzen und die parallel verarbeiteten Eingangssignale dann digital weiter zu verarbeiten. Nachteilig hierbei ist jedoch, dass die Verstärkungsfaktoren üblicherweise konstant sind und in dem analogen Schaltungsteil Übersteuerungseffekte auftreten können.

Die Druckschriften WO 01/99285 A1 und US 2002/012405 A1 offenbaren zwei aus dem Stand der Technik bekannte A/D-Wandler mit automatischer Verstärkungsregelung.

Der Erfindung liegt die Aufgabe zugrunde, ein Verfahren und eine Schaltungsanordnung zur Analog/Digitalwandlung elektrischer Signale zu schaffen, mit dem/der bei Einsatz nur eines A/D-Wandlers ein hoher Amplituden- bzw. Dynamikbereich eines analogen Eingangssignals verarbeitet werden kann.

Gelöst wird diese Aufgabe mit einem Verfahren gemäß Anspruch 1, einer digitalen Signalverarbeitungseinrichtung gemäß Anspruch 9 und einer Schaltungsanordnung gemäß Anspruch 10.

Ein wesentliches Prinzip besteht dabei darin, ein Trägersignals c(t) = g₁(t)^{∗}cos(ω_{C}t) durch das analoge Eingangssignal x(t) in seiner Amplitude zu modulieren und damit das Eingangssignal in der Weise zu skalieren, dass eine Übersteuerung eines folgenden A/D-Wandlers vermieden wird. Dazu wird eine Hüllkurve des modulierten digitalen Trägersignals ermittelt oder vorhergesagt und ein erster Amplituden- oder Verstärkungsfaktor g₁(t) des Trägersignals um einen vorbestimmten Betrag vermindert, wenn die Hüllkurve einen vorbestimmten ersten Schwellwert überschreitet und solange die Hüllkurve oberhalb eines vorbestimmten zweiten Schwellwertes liegt. Durch Beaufschlagen des skalierten und digitalisierten Eingangssignals mit einem geeignet ermittelten zweiten Verstärkungsfaktor g₂(m) wird die Wirkung des ersten Verstärkungsfaktors in dem digitalen Trägersignal wieder kompensiert und dann durch dessen Demodulation das Ausgangssignal x(n) erzeugt.

Ein Vorteil der erfindungsgemäßen Lösungen besteht insbesondere darin, dass das oben genannte 1/f-Rauschen in dem Steuersignal für die Verstärkung vermieden wird. Die abhängigen Ansprüche haben vorteilhafte Weiterbildungen der Erfindung zum Inhalt.

Weitere Einzelheiten, Merkmale und Vorteile der Erfindung ergeben sich aus der folgenden Beschreibung von bevorzugten Ausführungsformen anhand der Zeichnung. Es zeigt:
- Fig. 1: ein schematisches Blockschaltbild einer erfindungsgemäßen Schaltungsanordnung;
- Fig. 2: ein schematisches Blockschaltbild eines in der Schaltungsanordnung verwendeten digitalen Signalprozessors;
- Fig. 3: ein Flussdiagramm der Verstärkungsregelung in dem digitalen Signalprozessor;
- Fig.4: ein schematisches Funktionsschaltbild der Signalverarbeitung in einer Demodulator-/Dezimatoreinheit des Signalprozessors;
- Fig.5: ein schematisches Frequenzspektrum eines Eingangssignals der Demodulator/Dezimatoreinheit; und
- Fig. 6: ein schematisches Frequenzspektrum eines Ausgangssignals der Demodulator/Dezimatoreinheit.

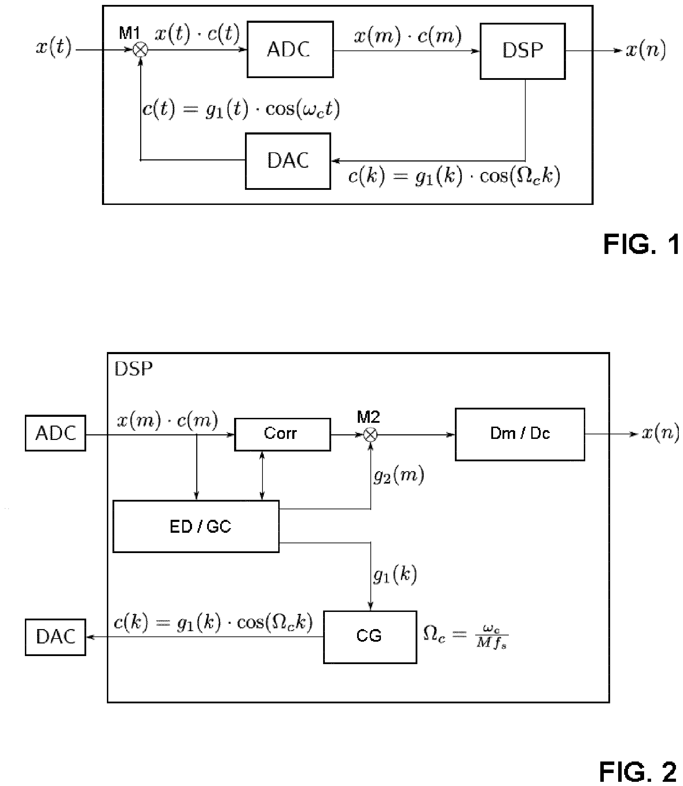

Figur 1 zeigt ein schematisches Blockschaltbild einer Ausführungsformen einer erfindungsgemäßen Schaltungsanordnung.

Diese Schaltungsanordnung umfasst einen ersten Multiplizierer M1, einen Analog/Digitalwandler ADC, einen digitalen Signalprozessor DSP, der vorzugsweise in Form eines FPGA (field-programmable gate array) realisiert ist, sowie einen Digital/Analogwandler DAC. Alle diese Komponenten können bevorzugt auch als eine Anwendungsspezifische integrierte Schaltung (ASIC - application-specific integrated circuit) realisiert sein, die als solche einen Analog/Digital-Wandler darstellt, dem ein analoges Eingangssignal x(t) zugeführt wird und an deren Ausgang das digital gewandelte Ausgangssignal x(n) anliegt.

Das analoge Eingangssignal x(t) liegt gemäß Figur 1 an einem ersten Eingang des ersten Multiplizierers M1 an. Ein Ausgang des ersten Multiplizierers M1 ist mit einem Eingang des Analog/Digitalwandlers ADC verbunden, dessen Ausgang an einem Eingang des digitalen Signalprozessors DSP anliegt. An einem ersten Ausgang des digitalen Signalprozessors DSP liegt das digital gewandelte Ausgangssignal x(n) an, während ein zweiter Ausgang des digitalen Signalprozessors DSP mit einem Eingang des Digital/Analogwandlers DAC verbunden ist. Dessen Ausgang liegt schließlich an einem zweiten Eingang des ersten Multiplizierers M1 an.

Der erste Multiplizierer M1 kann in Form einer Skalierungsschaltung oder einer Amplituden-Modulationsschaltung oder auf andere bekannte Weise realisiert werden.

Der Analog/Digitalwandler ADC (A/D-Wandler) ist ebenfalls ein an sich bekannter Baustein und wird so gewählt, dass damit eine Über-Abtastung (Oversampling) des analogen Eingangssignals x(t) mit einer Abtastrate (Abtastfrequenz) von L^{∗}f_{S} möglich ist, wobei f_{S} die Abtastrate gemäß dem Abtasttheorem (also das Zweifache der maximalen Frequenz des analoges Eingangssignal x(t)) darstellt und der erste Faktor L>1 ist.

Der Digital/Analogwandler DAC (D/A-Wandler) ist ebenfalls an sich bekannt und wird so gewählt, dass dieser mit einer Abtastrate (Abtastfrequenz) von M^{∗}f_{S} arbeiten kann, wobei f_{S} die Abtastrate gemäß dem Abtasttheorem und der zweite Faktor M>1 ist (Oversampling).

Die Faktoren L und M können gleich oder unterschiedlich groß sein.

Mit dieser Schaltungsanordnung wird das analoge Eingangssignal x(t) wie folgt in ein digitales Ausgangssignal x(n) umgewandelt:
Das analoge Eingangssignal x(t) wird mittels des ersten Multiplizierers M1 mit einem analogen Trägersignal c(t) = g₁(t)*cos(ω_{c}t) multipliziert, das sich aus einem analogen ersten zeitvariablen Amplituden- bzw. Verstärkungsfaktor g₁(t) und der Trägerfrequenz ω_{C} = 2πf_{C} zusammensetzt. Durch die nachfolgend noch erläuterte Bemessung des ersten Verstärkungsfaktors g₁(t) erfolgt eine Amplitudenmodulation des Trägersignals c(t) durch das Eingangssignal x(t) und damit eine Skalierung des Eingangssignals x(t) in dem Maße, dass eine Übersteuerung des folgenden A/D-Wandlers ADC vermieden wird. Das analoge Trägersignal c(t) wird, wie anhand von Figur 2 noch erläutert werden wird, vorzugsweise in der digitalen Ebene durch den Signalprozessor DSP erzeugt und mit dem D/A-Wandler DAC in das analoge Trägersignal c(t) umgewandelt.

Gemäß Figur 1 wird das am Ausgang des ersten Multiplizierers M1 anliegende skalierte analoge Eingangssignal x(t)*c(t) dann mittels des A/D-Wandlers ADC vorzugsweise mit der Abtastrate L^{∗}f_{S} überabgetastet und quantisiert.

Das somit skalierte und digitalisierte Eingangssignal x(m)*c(m) wird dem digitalen Signalprozessor DSP zugeführt, mit dem in der digitalen Ebene sowohl das digitale Ausgangssignal x(n) mit einer ggf. reduzierten, d.h. dem Abtasttheorem entsprechenden Abtastrate f_{S}, als auch das digitale Trägersignal c(k) = g₁(k)^{∗}cos(Ω_{C}k) mit dem digitalen ersten Verstärkungsfaktor g₁(k) erzeugt wird.

Figur 2 zeigt ein Block- und Funktionsschaltbild der mit dem digitalen Signalprozessor DSP erzeugten Signale, wobei auch der A/D-Wandler ADC, dessen Ausgang an dem Eingang des Signalprozessors DSP anliegt, sowie der D/A-Wandler DAC dargestellt ist, dessen Eingang mit dem zweiten Ausgang des Signalprozessors DSP verbunden ist.

Mit dem digitalen Signalprozessor DSP wird eine Einheit ED/GC realisiert, die einen Hüllkurven-Detektor/Prädiktor (ED) zur Ermittlung oder Vorhersage einer zeitlichen Hüllkurve des digitalen Eingangssignals sowie eine Verstärkungsregelung (GC) aufweist. Ferner wird mit dem digitalen Signalprozessor DSP eine optionale Korrektureinheit Corr, ein zweiter Multiplizierer M2, eine Demodulator- und Dezimatoreinheit Dm/Dc sowie ein Trägerfrequenzgenerator CG realisiert.

Das skalierte und digitalisierte Eingangssignal x(m)*c(m) wird einem Eingang der Korrektureinheit Corr sowie einem Eingang der Einheit ED/GC zugeführt. Über einen Ausgang der Korrektureinheit Corr gelangt das digitale, optional korrigierte Eingangssignal x(m)*c(m) an einen ersten Eingang des zweiten Multiplizierers M2.

Die Einheit ED/GC ist mit einem ersten Ausgang mit einem Eingang des Trägerfrequenzgenerators CG und mit einem zweiten Ausgang mit einem zweiten Eingang des zweiten Multiplizierers M2 verbunden. Ein Ausgang des zweiten Multiplizierers M2 liegt an einem Eingang der Demodulator- und Dezimatoreinheit Dm/Dc an, deren Ausgang den ersten Ausgang des digitalen Signalprozessors DSP bildet, an dem das digital gewandelte Ausgangssignal x(n) anliegt. Der Ausgang des Trägerfrequenzgenerators CG bildet den zweiten Ausgang des digitalen Signalprozessors DSP, an dem das digitale Trägersignal c(k) = g₁(k)^{∗}cos(Ω_{C}k) anliegt, das dem Eingang des D/A-Wandlers DAC zugeführt wird.

Der in Figur 2 gezeigte digitale Signalprozessor DSP arbeitet dabei wie folgt:
Die Einheit ED/GC dient zur Berechnung oder Vorhersage einer digitalen, vorzugsweise überabgetasteten, zeitlich variierenden Einhüllenden-Kurve (Hüllkurve) des skalierten und digitalisierten Eingangssignals x(m)*c(m), sowie zur Erzeugung des digitalen, zeitlich veränderlichen ersten Verstärkungsfaktors g₁(k), dessen Größe in Abhängigkeit von der Amplitude der Hüllkurve ermittelt bzw. verändert wird und der an dem ersten Ausgang der Einheit ED/GC anliegt.

Der erste Verstärkungsfaktor g₁(k) wird dem Trägerfrequenzgenerator CG zugeführt, der an seinem Ausgang das vorzugsweise mit einer Über-Abtastrate M^{∗}f_{S} überabgetastete, amplitudenmodulierte digitale Trägersignal c(k) = g₁(k)^{∗}cos(Ω_{C}k) mit Ω_{C} = ω_{C}/(M^{∗}f_{S}) erzeugt, das dann mit dem D/A-Wandler DAC in das analoge Trägersignal c(t) = g₁(t)^{∗}cos(ω_{C}t) umgewandelt und an den zweiten Eingang des ersten Multiplizierers M1 angelegt wird.

Die Einheit ED/GC erzeugt weiterhin an ihrem zweiten Ausgang einen digitalen zweiten Verstärkungsfaktor g₂(m), der einen digitalen Re-Skalierungsfaktor darstellt und mit dem die oben erläuterte Skalierung des analogen Eingangssignals x(t) mit dem Trägersignal c(t) bzw. dem ersten Verstärkungsfaktor g₁(t) zumindest weitgehend exakt wieder kompensiert bzw. rückgängig gemacht wird.

Um eine möglichst exakte Kompensation zu erzielen, wird der zweite Verstärkungsfaktor g₂(m) vorzugsweise nicht nur durch Invertierung des ersten Verstärkungsfaktors g₁(k) ermittelt, sondern es werden zusätzlich möglichst weitgehend auch die internen Verzögerungen und Filtereigenschaften der Schaltung sowie die ggf. unterschiedlichen Abtastraten L^{∗}f_{S} und M^{∗}f_{S} in dem Signalpfad oder in zumindest einem Teil des Signalpfades zwischen dem Trägerfrequenzgenerator CG, dem D/A-Wandler DAC, dem ersten Multiplizierer M1, dem A/D-Wandler ADC und dem zweiten Multiplizierer M2 mit eingerechnet.

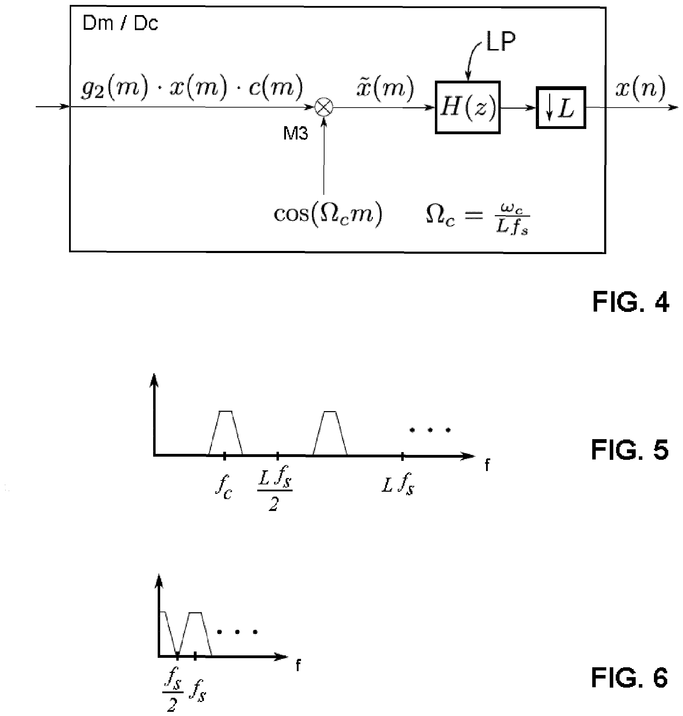

Durch Multiplikation des digitalen Eingangssignals x(m)^{∗}c(m) mit dem zweiten Verstärkungsfaktor g₂(m) mittels des zweiten Multiplizierers M2 wird dann das re-skalierte digitale Eingangssignal g₂(m)^{∗}x(m)^{∗}c(m) erzeugt, dessen Frequenzspektrum in Figur 5 gezeigt ist. Darin bezeichnet f_{C} die Trägerfrequenz, fs die Abtastrate (Abtastfrequenz) und L den genannten ersten Faktor L der Überabtastung der Analog/Digitalwandlung.

Die dem zweiten Multiplizierer M2 optional vorgeschaltete Korrektureinheit Corr dient vorzugsweise dazu, vor der Beaufschlagung des digitalen Eingangssignals x(m)^{∗}c(m) mit dem genannten zweiten Verstärkungsfaktor g₂(m) eventuell verbliebene fehlerhafte Abtastwerte auf Grund unterschiedlicher Filtercharakteristiken zwischen der Digital/Analog-Wandlung und der Analog/Digital-Wandlung zu kompensieren, und zwar insbesondere dann, wenn der Faktor g₂(m) nur durch Invertierung des ersten Verstärkungsfaktors g₁(k) ermittelt wird oder nicht genau genug dem verzögerten, gefilterten und invertierten Wert von g₁(k) entspricht. Die Korrektureinheit Corr kann dafür beispielsweise an den Stellen der Verstärkungsanpassung mithilfe eines Präzidierers arbeiten.

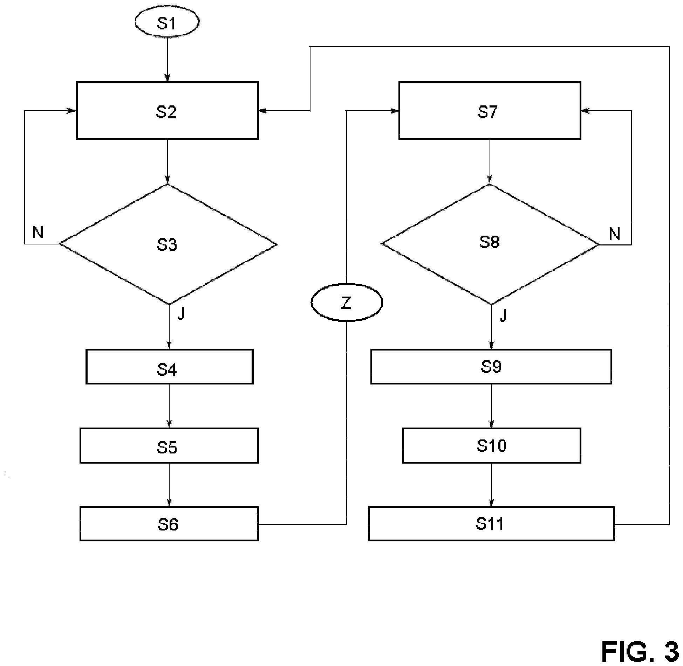

Ein Flussdiagram zur Ermittlung des ersten und zweiten Verstärkungsfaktors g₁(k), g₂(m) ist in Figur 3 gezeigt.

Der Ablauf wird mit einem ersten Schritt S1 gestartet. Mit einem zweiten Schritt S2 wird zunächst die Einhüllenden-Kurve (Hüllkurve) des skalierten und digitalisierten Eingangssignals x(m)^{∗}c(m) in an sich bekannter Weise ermittelt oder vorhersagt. Mit einem dritten Schritt S3 wird dann abgefragt, ob diese ermittelte oder vorhergesagte Hüllkurve einen vorbestimmten ersten oberen Schwellwert überschreitet. Dieser erste Schwellwert kann zum Beispiel in der Weise festgelegt werden, dass er einem Eingangssignalpegel entspricht, der so hoch ist, dass er von dem eingesetzten Analog/Digital-Wandler ADC noch verzerrungsfrei verarbeitet werden kann und angemessen weit unter der Vollaussteuerung des Analog/Digital-Wandlers ADC liegt. Der erste Schwellwert liegt dabei vorzugsweise so weit unter der Vollaussteuerung, dass keine Übersteuerung im analogen Schaltkreis auftritt, jedoch so nahe an der Vollaussteuerung, dass ein möglichst geringer Dynamikverlust durch die Verstärkungsanpassung resultiert.

Wenn dieser erste Schwellwert nicht überschritten wird, erfolgt ein Rücksprung zu dem zweiten Schritt S2. Wenn der erste Schwellwert überschritten wird, so wird mit einem vierten Schritt S4 der erste Verstärkungsfaktor g₁(k) in dem Maße verkleinert, dass die damit nach der genannten Modulation erzeugte Hüllkurve um den Faktor g₁(k) verkleinert ist.

Dies kann zum Beispiel in der Weise erfolgen, dass der erste Verstärkungsfaktor g₁(k) einmalig um einen konstanten vorbestimmten Betrag vermindert oder zeitlich monoton fallend vermindert wird, wobei im letztgenannten Fall darauf geachtet werden muss, dass keine Übersteuerung im Analogteil der Schaltung auftritt.

Wenn der erste Verstärkungsfaktor g₁(k) einmalig um einen konstanten vorbestimmten Betrag vermindert wird, so erfolgt dies vorzugsweise während des nächsten Nulldurchgangs des Trägersignals, um einen möglichst geringen Sprung des Trägersignals zu erzeugen. Vorteilhaft sind dabei Verstärkungsfaktoren, die eine Potenz von 2 darstellen, da diese eine einfache Implementierung ermöglichen.

Anschließend wird dann mit einem optionalen fünften Schritt S5 die Korrektureinheit Corr wie oben beschrieben angesteuert.

Mit einem sechsten Schritt S6 wird dann der zweite Verstärkungsfaktor g₂(m) entsprechend erhöht, und zwar durch Invertierung des verminderten ersten Verstärkungsfaktors g₁(k), wobei der zweite Verstärkungsfaktor g₂(m) bevorzugt auch mit den oben genannten internen Verzögerungen und Filtereigenschaften der Schaltung beaufschlagt wird.

Um nach Ablauf einer vorbestimmten, vorzugsweise einstellbaren oder durch die Signallaufzeit in der Schaltung gegebenen Zeitdauer Z einer während dieser Zeitdauer Z eingetretenen Absenkung des Eingangssignalpegels Rechnung zu tragen, wird dann mit einem siebten Schritt S7 die sich mit dem verminderten ersten Verstärkungsfaktor g₁(k) ergebende Hüllkurve des skalierten und digitalisierten Eingangssignals x(m)*c(m) in an sich bekannter Weise ermittelt oder vorhersagt.

Mit einem achten Schritt S8 wird dann abgefragt, ob diese Hüllkurve einen vorbestimmten zweiten Schwellwert unterschreitet. Im Gegensatz zur der Abfrage mit dem dritten Schritt S3, mit dem umgehend auf hohe Eingangssignalpegel reagiert wird, wird mit dem achten Schritt S8 vorzugsweise geprüft, ob die Hüllkurve den zweiten Schwellwert für eine vorbestimmte Zeitdauer unterschreitet. Der Grund liegt darin, dass das Eingangssignal ein dynamisches Signal mit gelegentlich auch sehr kleinen Abtastwerten ist und die nachfolgende Erhöhung des ersten Verstärkungsfaktors g₁(k) nur dann stattfinden soll, wenn im Wesentlichen alle Abtastwerte kleiner als der zweite Schwellwert sind. Andernfalls könnte durch eine zu frühzeitige Erhöhung des ersten Verstärkungsfaktors g₁(t) der analoge Schaltkreis übersteuert werden.

Wenn also die Abfrage mit dem achten Schritt S8 verneint wird, erfolgt ein Rücksprung zu dem siebten Schritt S7. Wenn der zweite Schwellwert wie erläutert unterschritten wird, so wird mit einem neunten Schritt S9 die mit dem vierten Schritt S4 vorgenommene Verminderung des ersten Verstärkungsfaktors g₁(k) wieder rückgängig gemacht, d.h. dieser wieder erhöht.

Um ein ständiges oder zu häufiges Vermindern und Erhöhen der Verstärkungsfaktoren zu vermeiden, ist der zweite Schwellwert vorzugsweise nicht gleich dem um den ersten Verstärkungsfaktor g₁(k) verminderten ersten Schwellwert, sondern um einen vorbestimmten Betrag kleiner als dieser. Der zweite Schwellwert kann jedoch auch gleich dem um den ersten Verstärkungsfaktor g₁(k) verminderten ersten Schwellwert sein, er sollte jedoch nicht größer als dieser gewählt werden.

Anschließend wird dann mit einem optionalen zehnten Schritt S10 wieder wie im fünften Schritt S5 die Korrektureinheit Corr angesteuert.

Mit einem elften Schritt S11 wird schließlich auch die in dem sechsten Schritt S6 vorgenommene Erhöhung des zweiten Verstärkungsfaktors g₂(m) wieder rückgängig gemacht, und der Ablauf wird mit einem Rücksprung zu dem zweiten Schritt S2 wiederholt.

Zeitlich parallel dazu wird gemäß Figur 2 das am Ausgang des zweiten Multiplizierers M2 anliegende, mit dem wie oben beschrieben ermittelten zweiten Verstärkungsfaktor g₂(m) re-skalierte digitale Eingangssignal g₂(m)*x(m)*c(m) der digitalen Demodulator- und Dezimatoreinheit Dm/Dc zugeführt, deren Funktionsschaltbild in Figur 4 gezeigt ist.

Die Demodulator- und Dezimatoreinheit Dm/Dc dient zur Amplitudendemodulation des re-skalierten digitalen Eingangssignals g₂(m)*x(m)*c(m) und umfasst zu diesem Zweck einen dritten Multiplizierer M3, an dessen erstem Eingang das Eingangssignal g₂(m)^{∗}x(m)^{∗}c(m) anliegt und dessen zweitem Eingang das Trägerfrequenzsignal cos(Ω_{C}m) mit Ω_{C} = w_{C}/(L^{∗}f_{S}) zugeführt wird. Das am Ausgang des dritten Multiplizierers M3 anliegende Ausgangssignal wird dann einem Tiefpass LP und einer Einheit L zur Heruntertaktung zugeführt, um schließlich das demodulierte und auf die Abtastrate f_{S} dezimierte (heruntergetaktete) digitale Ausgangssignal x(n) zu erzeugen, dessen Frequenzspektrum in Figur 6 gezeigt ist. Dabei bezeichnet wiederum f_{S} die Abtastrate.

Dieses Ausgangssignal x(n) erfasst einen Dynamikbereich, der sich zum Beispiel bei einer Halbierung des ersten Verstärkungsfaktors g₁(k) um etwa 6 dB erweitert.

Die beschriebene Signalverarbeitung in der digitalen Ebene erfolgt vorzugsweise in Form eines in Hardware oder Software implementierten Verfahrens, bei dem vorzugsweise die folgenden vier Algorithmen realisiert bzw. unterschieden werden:
Mit einem ersten Algorithmus wird die Amplituden-Demodulation sowie ggf. die Dezimation (Heruntertaktung) der Abtastrate des digitalen Eingangssignals g₂(m)^{∗}x(m)^{∗}c(m) zur Erzeugung des digitalen Ausgangssignals x(n) mit der Abtastrate fₛ vorgenommen.

Mit einem zweiten Algorithmus wird die vorzugsweise überabgetastete zeitliche Hüllkurve des digitalen Eingangssignals x(m)^{∗}c(m) ermittelt und durch Vergleich mit den genannten Schwellwerten der zeitabhängige ersten Verstärkungsfaktor g₁(t) bestimmt.

Mit einem dritten Algorithmus wird das mit der Abtastrate M ^{∗} f_{S} vorzugsweise überabgetastete digitale Trägersignal c(k) = g₁(k)^{∗}cos(Ω_{C}k) mit Ω_{C} = ω_{C} /(M^{∗}f_{S}) erzeugt, das dem Digital/Analogwandler DAC zur Erzeugung des analogen Trägersignals c(t) = g₁(t)^{∗}cos(ω_{C}t) zugeführt wird.

Mit einem vierten Algorithmus wird schließlich der zweite Verstärkungsfaktor g₂(m) wie oben beschrieben erzeugt.

## Patentansprüche

1. Verfahren zur Umwandlung eines analogen Eingangssignals (x(t)) in ein digitales Ausgangssignal (x(n)) mit folgenden Schritten:
- Erzeugen eines analogen Trägersignals (c(t) = g₁(t)^{∗}cos(ω_{C}t)) mit einem analogen ersten Verstärkungsfaktor (g₁(t)) und einer Trägerfrequenz (u_{C} = 2πf_{C}),
- Modulieren der Amplitude des analogen Trägersignals (c(t)) mit dem analogen Eingangssignal (x(t)),
- Umwandeln des amplitudenmodulierten Trägersignals (x(t)^{∗}c(t)) in ein digitales Eingangssignal (x(m)^{∗}c(m)),
- Ermitteln oder Vorhersagen einer zeitlichen Hüllkurve des digitalen Eingangssignals (x(m)*c(m)),
- Vermindern des ersten Verstärkungsfaktors (g₁(t)) um einen vorbestimmten Betrag, wenn die Hüllkurve einen vorbestimmten ersten Schwellwert überschreitet und solange die Hüllkurve oberhalb eines vorbestimmten zweiten Schwellwertes liegt, sowie Modulieren der Amplitude des mit dem verminderten ersten Verstärkungsfaktor (g₁(t)) erzeugten analogen Trägersignals (c(t) = g₁(t)^{∗}cos(ω_{C}t)) durch das analoge Eingangssignal (x(t)),
- Ermitteln und Beaufschlagen des digitalen Eingangssignals (x(m)^{∗}c(m)) mit einem digitalen zweiten Verstärkungsfaktor (g₂(m)) zur Kompensation des analogen ersten Verstärkungsfaktors g₁(t), und
- Demodulieren des beaufschlagten digitalen Eingangssignals (g₂(m)^{∗}x(m)^{∗}c(m)) zur Erzeugung des digitalen Ausgangssignals (x(n)).

2. Verfahren nach Anspruch 1,
bei dem das Vermindern des analogen ersten Verstärkungsfaktors (g₁(t)) wieder rückgängig gemacht wird, wenn die Hüllkurve einen vorbestimmten zweiten Schwellwert unterschreitet.

3. Verfahren nach Anspruch 2,
bei dem der zweite Schwellwert kleiner ist als der um den ersten Verstärkungsfaktor g₁(k) verminderte erste Schwellwert.

4. Verfahren nach Anspruch 1,
bei dem das Trägersignal als digitales Trägersignal (c(k) = g₁(k)^{∗}cos(Ω_{C}k)) mit einem digitalen ersten Verstärkungsfaktor (g₁(k)) erzeugt und vor der Modulation in das analoge Trägersignal (c(t) = g₁(t)^{∗}cos(ω_{C}t)) mit dem analogen ersten Verstärkungsfaktor g₁(t) umgewandelt wird.

5. Verfahren nach Anspruch 4,
bei dem der digitale zweite Verstärkungsfaktor (g₂(m)) durch Invertieren des digitalen ersten Verstärkungsfaktors (g₁(k)) erzeugt wird.

6. Verfahren nach Anspruch 5,
bei dem der digitale zweite Verstärkungsfaktor (g₂(m)) mit in dem Signalpfad zwischen der Erzeugung des Trägersignals (c(t) = g₁(t)^{∗}cos(ω_{C}t)) und der Modulation mit dem analogen Eingangssignal (x(t)) vorhandenen Verzögerungen und Filtereigenschaften beaufschlagt wird.

7. Verfahren nach Anspruch 1,
bei dem das amplitudenmodulierte Trägersignal (x(t)^{∗}c(t)) durch Überabtastung mit einer Abtastrate von L^{∗}f_{S} in das digitale Eingangssignal (x(m)^{∗}c(m)) umgewandelt und nach der Demodulation wieder auf eine dem Abtasttheorem entsprechende Abtastrate von f_{S} heruntergetaktet wird.

8. Ein in Software implementiertes Verfahren zur Durchführung der Schritte gemäß einem der Ansprüche 1 bis 7.

9. Digitale Signalverarbeitungseinheit, umfassend Mittel zur Ausführung des Verfahrens nach Anspruch 8.

10. Schaltungsanordnung zur Umwandlung eines analogen Eingangssignals (x(t)) in ein digitales Ausgangssignal (x(n)) nach einem Verfahren gemäß einem der Ansprüche 1 bis 7, mit:
- einem Trägerfrequenzgenerator (CG, DAC) zum Erzeugen eines analogen Trägersignals (c(t) = g₁(t)^{∗}cos(w_{C}t)) mit einem analogen ersten Verstärkungsfaktor (g₁(t)) und einer Trägerfrequenz (u_{C} = 2πf_{C}),
- einem ersten Multiplizierer (M1) zur Amplitudenmodulation des analogen Trägersignals (c(t)) mit dem analogen Eingangssignal (x(t)),
- einem Analog/Digital-Wandler (ADC) zur Umwandlung des amplitudenmodulierten Trägersignals (x(t)^{∗}c(t)) in ein digitales Eingangssignal (x(m)^{∗}c(m)),
- einem Hüllkurven-Detektor/Prädiktor (ED) zur Ermittlung oder Vorhersage einer zeitlichen Hüllkurve des digitalen Eingangssignals (x(m)^{∗}c(m)),
- einer Einheit (GC) zur Verstärkungsregelung, zum Vermindern des ersten Verstärkungsfaktors (g₁(t)) um einen vorbestimmten Betrag, wenn die Hüllkurve einen vorbestimmten ersten Schwellwert überschreitet und solange die Hüllkurve oberhalb eines vorbestimmten zweiten Schwellwertes liegt, und zum Erzeugen eines digitalen zweiten Verstärkungsfaktors (g₂(m)) zur Kompensation des analogen ersten Verstärkungsfaktors g₁(t),
- einem zweiten Multiplizierer (M2) zur Beaufschlagung des digitalen Eingangssignals (x(m)^{∗}c(m)) mit dem digitalen zweiten Verstärkungsfaktor (g₂(m)), sowie
- einem Demodulator (Dm/Dc) zum Erzeugen des digitalen Ausgangssignals (x(n)) durch Demodulation des beaufschlagten digitalen Eingangssignals (g₂(m)^{∗}x(m)^{∗}c(m)).

11. Schaltungsanordnung nach Anspruch 10, mit
- einem digitalen Trägerfrequenzgenerator (CG) zum Erzeugen eines digitalen Trägersignals (c(k) = g₁(k)^{∗}cos(Ω_{C}k)) mit einem digitalen ersten Verstärkungsfaktor g₁(k) und Ω_{C} = ω_{C}/(M^{∗}f_{S}), sowie
- einem Digital/Analog-Wandler (DAC), dem das digitale Trägersignal zur Umwandlung in das analoge Trägersignal (c(t)) mit dem analogen ersten Verstärkungsfaktor (g₁(t)) zugeführt wird.

12. Schaltungsanordnung nach Anspruch 10, bei der der Analog/Digital-Wandler (ADC) zur Erzeugung des digitalen Eingangssignals (x(m)^{∗}c(m)) durch Überabtastung des amplitudenmodulierten Trägersignals (x(t)^{∗}c(t)) mit einer Abtastrate von L^{∗}f_{S} vorgesehen ist, und bei der der Demodulator (Dm) einen Dezimator (Dc) zur Heruntertaktung des demodulierten, mit dem digitalen zweiten Verstärkungsfaktor (g₂(m)) beaufschlagten digitalen Eingangssignals (g₂(m)^{∗}x(m)^{∗}c(m)) auf eine dem Abtasttheorem entsprechende Abtastrate von f_{S} aufweist.

13. Schaltungsanordnung nach einem der Ansprüche 10 bis 12, mit einem digitalen Signalprozessor (DSP) oder FPGA, mit dem der digitale Trägerfrequenzgenerator (CG), die Einheit (GC) zur Verstärkungsregelung, der HüllkurvenDetektor/Prädiktor (ED), der zweite Multiplizierer (M2) sowie der Demodulator/Dezimator (Dm/Dc) realisiert sind, und dem das digitale Eingangssignal (x(m)^{∗}c(m)) zum Erzeugen des digitalen Trägersignals (c(k)) sowie des digitalen Ausgangssignals (x(n)) nach mindestens einem der Ansprüche 1 bis 9 zugeführt wird.

14. Schaltungsanordnung nach einem der Ansprüche 10 bis 13, die in Form einer Anwendungsspezifischen integrierten Schaltung (ASIC - application-specific integrated circuit) realisiert ist, die einen Eingang für das analoge Eingangssignal x(t) und einen Ausgang für das digital gewandelte Ausgangssignal x(n) aufweist.

## Claims

1. A method for converting an analogue input signal (x(t)) into a digital output signal (x(n)) comprising the following steps:
- generating an analogue carrier signal (c(t) = g₁(t)^{∗}cos(ω_{C}t)) with an analogue first amplification factor (g₁(t)) and a carrier frequency (ω_{C} = 2πf_{C}),
- modulating the amplitude of the analogue carrier signal (c(t)) with the analogue input signal (x(t)),
- converting the amplitude-modulated carrier signal (x(t)^{∗}c(t)) into a digital input signal (x(m)^{∗}c(m)),
- determining or predicting a temporal envelope curve of the digital input signal (x(m)^{∗}c(m)),
- reducing the first amplification factor (g₁(t)) by a predetermined amount, if the envelope curve exceeds a predetermined first threshold value and as long as the envelope curve lies above a predetermined second threshold value, as well as modulating the amplitude of the analogue carrier signal (c(t) = g₁(t)^{∗}cos(ω_{C}t)) generated with the reduced first amplification factor (g₁(t)) by the analogue input signal (x(t)),
- determining and impacting the digital input signal (x(m)^{∗}c(m)) with a digital second amplification factor (g₂(m)) for compensation of the analogue first amplification factor g₁(t), and
- demodulating the impacted digital input signal (g₂(m)^{∗}x(m)^{∗}c(m)) for generating the digital output signal (x(n)).

2. The method according to claim 1,
in which the reducing of the analogue first amplification factor (g₁(t)) is reversed, if the envelope curve falls below a predefined second threshold value.

3. The method according to claim 2,
in which the second threshold value is less than the first threshold value reduced by the first amplification factor g₁(k).

4. The method according to claim 1,
in which the carrier signal as a digital carrier signal (c(k) = g₁(k)^{∗}cos(Ω_{C}k)) is generated with a digital first amplification factor (g₁(k)) and prior to modulation is converted into the analogue carrier signal (c(t) = g₁(t)^{∗}cos(ω_{C}t)) with the analogue first amplification factor g₁(t).

5. The method according to claim 4,
in which the digital second amplification factor (g₂(m)) is generated by inverting the digital first amplification factor (g₁(k)).

6. The method according to claim 5,
in which the digital second amplification factor (g₂(m)) is impacted with delays and filter properties present in the signal path between generating the carrier signal (c(t) = g₁(t)^{∗}cos(ω_{C}t)) and modulating it with the analogue input signal (x(t)).

7. The method according to claim 1,
in which the amplitude-modulated carrier signal (x(t)^{∗}c(t)) is converted into the digital input signal (x(m)^{∗}c(m)) through oversampling at a sampling rate of L^{∗}f_{S} and following demodulation is downclocked again to a sampling rate of f_{S} in line with the sampling theorem.

8. A method implemented in software for performing the steps according to one of claims 1 to 7.

9. A digital signal processing unit comprising means for executing the method according to claim 8.

10. A circuit arrangement for converting an analogue input signal (x(t)) into a digital output signal (x(n)) according to a method as per one of claims 1 to 7, with:
- a carrier frequency generator (CG, DAC) for generating an analogue carrier signal (c(t) = g₁(t)*cos(ω_{C}t)) with an analogue first amplification factor (g₁(t)) and a carrier frequency (ω_{C} = 2πf_{C}),
- a first multiplier (M1) for modulating the amplitude of the analogue carrier signal (c(t)) with the analogue input signal (x(t)),
- an analogue/digital converter (ADC) for converting the amplitude-modulated carrier signal (x(t)*c(t)) into a digital input signal (x(m)*c(m)),
- an envelope curve detector/predictor (ED) for determining or predicting a temporal envelope curve of the digital input signal (x(m)*c(m)),
- a unit (GC) for amplification control, for reducing the first amplification factor (g₁(t)) by a predetermined amount if the envelope curve exceeds a predetermined first threshold value and as long as the envelope curve lies above a predetermined second threshold value, and for generating a digital second amplification factor (g₂(m)) for compensation of the analogue first amplification factor g₁(t),
- a second multiplier (M2) for impacting the digital input signal (x(m)*c(m)) with the digital second amplification factor (g₂(m)), as well as
- a demodulator (Dm/Dc) for generating the digital output signal (x(n)) through demodulation of the acted-on digital input signal (g₂(m)*x(m)*c(m)).

11. The circuit arrangement according to claim 10, with
- a digital carrier frequency generator (CG) for generating a digital carrier signal (c(k) = g₁(k)*cos(Ω_{C}k)) with a digital first amplification factor g₁(k) and Ω_{C} = ω_{C}/(M*f_{S}), as well as
- a digital/analogue converter (DAC), to which is fed the digital carrier signal for conversion into the analogue carrier signal (c(t)) with the analogue first amplification factor (g₁(t)).

12. The circuit arrangement according to claim 10,
in which the analogue/digital converter (ADC) is provided for generating the digital input signal (x(m)^{∗}c(m)) by oversampling the amplitude-modulated carrier signal (x(t)^{∗}c(t)) at a sampling rate of L^{∗}f_{S}, and in which the demodulator (Dm) comprises a decimator (Dc) for downclocking the demodulated digital input signal (g₂(m)^{∗}x(m)^{∗}c(m)) impacted with the digital second amplification factor (g₂(m)) to a sampling rate of f_{S} in line with the sampling theorem.

13. The circuit arrangement according to one of claims 10 to 12,
with a digital signal processor (DSP) or FPGA, with which the digital carrier frequency generator (CG), the unit (GC) for amplification control, the envelope curve detector/predictor (ED), the second multiplier (M2) as well as the demodulator/decimator (Dm/Dc) are realised, and to which is fed the digital input signal (x(m)^{∗}c(m)) for generating the digital carrier signal (c(k)) as well as the digital output signal (x(n)) according to at least one of claims 1 to 9.

14. The circuit arrangement according to one of claims 10 to 13,
which is realised in form of an application-specific integrated circuit (ASIC), which comprises an input for the analogue input signal x(t) and an output for the digitally converted output signal x(n).

## Revendications

1. Procédé de conversion d'un signal d'entrée analogique (x(t)) en un signal de sortie numérique (x(n)) comportant les étapes suivantes :
- génération d'un signal porteur analogique (c(t) = g₁(t)^{∗}cos((ω_{C}t)) avec un premier facteur de gain analogique (g₁(t)) et une fréquence porteuse (ω_{C} = 2πf_{C}),
- modulation de l'amplitude du signal porteur analogique (c(t)) avec le signal d'entrée analogique (x(t)),
- conversion du signal porteur modulé en amplitude (x(t)^{∗}c(t)) en un signal d'entrée numérique (x(m)^{∗}c(m)),
- détermination ou prédiction d'une enveloppe temporelle du signal d'entrée numérique (x(m)^{∗}c(m)),
- réduction du premier facteur de gain (g₁(t)) d'une valeur prédéterminée si la courbe enveloppe dépasse une première valeur seuil prédéterminée et tant que la courbe enveloppe est supérieure à une deuxième valeur seuil prédéterminée, ainsi que la modulation de l'amplitude du signal porteur analogique (c(t) = g₁(t)^{∗}cos((ω_{C}t)) généré avec le premier facteur de gain (g₁(t)) réduit par le signal d'entrée analogique (x(t)),
- détermination et sollicitation du signal d'entrée numérique (x(m)^{∗}c(m)) avec un deuxième facteur de gain numérique (g₂(m)) pour compenser le premier facteur de gain analogique g₁(t), et
- démodulation du signal d'entrée numérique appliqué (g₂(m)^{∗}x(m)^{∗}c(m)) pour générer le signal de sortie numérique (x(n)).

2. Procédé selon la revendication 1,
dans lequel la réduction du premier facteur de gain analogique (g₁(t)) est à nouveau inversée lorsque la courbe enveloppe tombe en dessous d'une deuxième valeur seuil prédéterminée.

3. Procédé selon la revendication 2,
dans lequel la deuxième valeur seuil est inférieure à la première valeur seuil réduite du premier facteur de gain g₁(k).

4. Procédé selon la revendication 1,
dans lequel le signal porteur est généré en tant que signal porteur numérique (c(k) = g₁(k)^{∗}cos(Ω_{C}k)) avec un premier facteur de gain numérique (g₁(k)) et avant modulation en signal porteur analogique (c(t) = g₁(t)^{∗}cos((ω_{C}t)) est converti avec le premier facteur de gain analogique g₁(t).

5. Procédé selon la revendication 4,
dans lequel le deuxième facteur de gain numérique (g₂(m)) est généré en inversant le premier facteur de gain numérique (g₁(k)).

6. Procédé selon la revendication 5,
dans lequel le deuxième facteur de gain numérique (g₂(m)) est sollicité avec les retards et propriétés de filtre existants dans le trajet du signal entre la génération du signal porteur (c(t) = g₁(t)^{∗}cos((ω_{C}t)) et la modulation avec le signal d'entrée analogique (x(t)).

7. Procédé selon la revendication 1,
dans lequel le signal porteur modulé en amplitude (x(t)^{∗}c(t)) est converti en signal d'entrée numérique (x(m)^{∗}c(m)) par suréchantillonnage à une fréquence d'échantillonnage de L^{∗}f_{S} et, après démodulation, est de nouveau cadencé par f_{S} à un des taux d'échantillonnage correspondant du théorème d'échantillonnage

8. Procédé implémenté dans un logiciel pour réaliser les étapes selon une quelconque des revendications 1 à 7.

9. Unité de traitement de signal numérique comprenant des moyens pour mettre en œuvre le procédé selon la revendication 8.

10. Circuit pour convertir un signal d'entrée analogique (x(t)) en un signal de sortie numérique (x(n)) selon un procédé selon une des revendications 1 à 7, avec :
- un générateur de fréquence porteuse (CG, DAC) pour générer un signal porteur analogique (c(t) = g₁(t^{∗}cos((ω_{C}t)) avec un premier facteur de gain analogique (g₁(t)) et une fréquence porteuse (ω_{C} = 2πf_{C}),
- un premier multiplicateur (M1) de modulation d'amplitude du signal analogique porteur (c(t)) avec le signal analogique d'entrée (x(t)),
- un convertisseur analogique/numérique (ADC) pour convertir le signal porteur modulé en amplitude (x(t)^{∗}c(t)) en un signal numérique d'entrée (x(m)^{∗}c(m)),
- un détecteur/prédicteur d'enveloppe (ED) pour déterminer ou prédire une enveloppe temporelle du signal numérique d'entrée (x(m)^{∗}c(m)),
- une unité (GC) de commande de gain, pour réduire le premier facteur de gain (g₁(t)) d'une quantité prédéterminée si la courbe enveloppe dépasse une première valeur seuil prédéterminée et tant que la courbe enveloppe est supérieure à une deuxième valeur seuil prédéterminée, et pour générer un deuxième facteur de gain numérique (g₂(m)) pour compenser le premier facteur de gain analogique g₁(t),
- un deuxième multiplicateur (M2) pour appliquer le signal d'entrée numérique (x(m)^{∗}c(m)) avec le deuxième facteur de gain numérique (g₂(m)), et
- un démodulateur (Dm/Dc) pour générer le signal de sortie numérique (x(n)) en démodulant le signal d'entrée numérique appliqué (g₂(m)^{∗}x(m)^{∗}c(m)).

11. Circuit selon la revendication 10, avec
- un générateur de fréquence porteuse numérique (CG) pour générer un signal de porteuse numérique (c(k) = g₁(k)^{∗}cos(Ω_{C}k)) avec un premier facteur de gain numérique g₁(k) et Ω_{C} = ω_{C}/(M^{∗}f_{S}), et
- un convertisseur numérique/analogique (DAC) dans lequel le signal de porteuse numérique est alimenté pour être converti en signal de porteuse analogique (c(t)) avec le premier facteur de gain analogique (g₁(t)).

12. Circuit selon la revendication 10,
dans lequel le convertisseur analogique/numérique (ADC) pour générer le signal d'entrée numérique (x(m)^{∗}c(m)) en suréchantillonnant le signal porteur modulé en amplitude (x(t)^{∗}c(t)) avec une fréquence d'échantillonnage de L^{∗}f_{S} est fourni, et dans lequel le démodulateur (Dm) présente un décimateur (Dc) pour cadencer le signal d'entrée numérique démodulé (g₂(m)^{∗}x(m)^{∗}c(m)) sollicité avec le deuxième facteur de gain numérique (g₂(m)) à une fréquence d'échantillonnage de f_{S} correspondant à un des théorèmes d'échantillonnage.

13. Circuit selon une des revendications 10 à 12,
comportant un processeur de signal numérique (DSP) ou FPGA, avec lequel le générateur de fréquence porteuse numérique (CG), l'unité (GC) de commande de gain, le détecteur/prédicteur d'enveloppe (ED), le deuxième multiplicateur (M2) et le démodulateur/ décimateur (Dm/Dc) sont mis en œuvre, et dans lequel le signal d'entrée numérique (x(m)^{∗}c(m)) pour générer le signal de porteuse numérique (c(k)) et le signal de sortie numérique (x(n)) selon au moins une des revendications 1 à 9 est alimenté.

14. Circuit selon une des revendications 10 à 13,
qui est réalisé sous la forme d'un circuit intégré spécifique à l'application (ASIC), qui présente une entrée pour le signal d'entrée analogique x(t) et une sortie pour le signal de sortie converti numériquement x(n).
